# EUROPÄISCHE PATENTSCHRIFT

(11) **EP 4 142 439 B1**
(45) Veröffentlichungstag und Bekanntmachung des Hinweises auf die Patenterteilung: **02.09.2026**
(21) Anmeldenummer: 22192054.9
(22) Anmeldetag: 25.08.2022
(51) Int. Cl.: H05K 5/02, G06F 1/183, G06F 1/18

(54) **GEHÄUSESYSTEM**
HOUSING SYSTEM
SYSTÈME DE LOGEMENT

(30) Priorität: 26.08.2021 DE 202021104596 U
(43) Veröffentlichungstag der Anmeldung: 01.03.2023
(73) Patentinhaber: Weidmüller Interface GmbH & Co. KG, 32758 Detmold (DE)
(72) Erfinder: NIGGEMANN, Matthias, 32694 Dörentrup (DE); WALDHOFF, Marco, 32839 Steinheim (DE); BECKMANN, Cedric, 32805 Horn-Bad Meinberg (DE); WIND, Benjamin, 32760 Detmold (DE); BANCK, Annekathrin, 33619 Bielefeld (DE)
(74) Vertreter: Specht, Peter

(56) Entgegenhaltungen:
- WO-A1-2018/172363
- DE-U1- 9 102 932
- US-A1- 2004 136 167
- US-A1- 2015 289 388
- US-A1- 2020 053 888
- US-B2- 10 104 795

## Beschreibung

Die vorliegende Erfindung bezieht sich auf ein Gehäusesystem für elektrische und elektronische Baugruppen, insbesondere für Einplatinencomputer und Zubehör, nach dem Oberbegriff des Anspruchs 1.

Derartige Gehäusesysteme und Gehäuse sind in vielerlei Ausführungen bekannt.

Elektrische Baugruppen sind derzeit üblicherweise auf Leiterplatten unterschiedlicher Art aufgebaut und mit verschiedenen Bauelementen für Anschlüsse, Energieversorgung, Bedienung usw. wie z.B. Klemmen, Schalter, Anzeigen, Stellorganen, verbunden, welche in und/oder an dem Gehäuse angebracht werden, um einen möglichst kompakten Aufbau zu erzielen.

Das Gehäuse schützt die Baugruppen vor äußeren Einflüssen, bildet aber auch gleichzeitig einen Berührschutz von Teilen der Baugruppen mit hoher elektrischer Spannung und hoher Temperatur. Ein Gehäusesystem umfasst alle mechanischen Teile zum Aufbau des Gehäuses und bietet Erweiterungsmöglichkeiten. Dies ist besonders im experimentellen Aufbau, im Versuchsstadium von elektrischen und elektronischen Schaltkreisen wichtig, da eine häufige Änderung derselben mit dementsprechenden Zugriffen mit Öffnen des Gehäuses erfolgt.

Ein Beispiel eines Gehäuses zur Aufnahme einer elektrischen oder elektronischen Funktionsbaugruppe illustrieren die Dokumente US 2004/136167 A1 und WO 2018 / 172 363 A1.

Die bekannten Lösungen haben sich an sich bewährt. Es besteht aber ein ständiger Bedarf an Weiterentwicklung, wobei eine größere Funktionalität bei erhöhter Sicherheit, kompaktem Aufbau und geringerer Bauteilezahl geschaffen wird.

Die Lösung dieses Problems ist die Aufgabe der Erfindung. Die Erfindung löst diese Aufgabe durch den Gegenstand des Anspruchs 1. Weitere vorteilhafte Ausgestaltungen sind den übrigen Unteransprüchen zu entnehmnen.

Ein erfindungsgemäßes Gehäusesystem für elektrische und elektronische Baugruppen, insbesondere für Einplatinencomputer und Zubehör, mit einem Gehäuse, mit Seitenwänden und Einschubwänden und mit mindestens einem Deckel wird bereitgestellt. Das Gehäuse umfasst mindestens einen Grundrahmen mit den Seitenwänden und mit mindestens einer Ecksäule, wobei die mindestens eine Ecksäule Schnittstellen für externe Halterungen und interne Halterungen bildet.

Das erfindungsgemäße Gehäusesystem ist besonders vorteilhaft für Einplatinencomputer geeignet, welche eine Vielzahl von Anwendungsmöglichkeiten bieten. Diese Anwendungen sind beispielsweise Multimedia Player, Medienserver, Hausautomation, Steuerung und Webserver für 3D-Drucker, diverse Automatisierungsaufgaben, IoT-Server als Cloud, Testsoftware, eine Vielzahl von Versuchsaufbauten.

Um diesen Anforderungen gerecht zu werden, weist das erfindungsgemäße Gehäusesystem vorteilhaft universelle Schnittstellen für interne Halterungen und externe Halterungen für diverses Zubehör auf.

Die internen Halterungen ermöglichen vorteilhaft ein schnelles und einfaches Einsetzen von Zubehör, z.B. Erweiterungen, Lüfter, Kühler usw. in den Innenraum, wobei die externen Halterungen Befestigungsmöglichkeiten des Gehäuses an verschiedenen Positionen bieten. Gleichzeitig dienen die externen Halterungen auch zur einfachen und schnellen Montage von beispielsweise Kameras, Sensoren, Bedienungsmittel etc.

In dem erfindungsgemäßen Gehäusesystem weist der mindestens eine Grundrahmen vier Ecksäulen auf, die mit Seitenwänden fest verbunden sind. So ist vorteilhaft eine Gehäusegrundlage gebildet, die erweiterbar ist.

Dazu kann das Gehäuse mindestens einen Zusatzrahmen mit mindestens einer Ecksäule aufweisen, wodurch ein vorteilhaft einfacher Erweiterungsaufbau ermöglicht wird.

Es ist vorteilhaft, wenn der mindestens eine Zusatzrahmen vier Ecksäulen aufweist, von denen jeweils zwei Ecksäulen mit Seitenwänden fest verbunden sind, da sich auf diese Weise ein kompakter und leicht veränderbarer Aufbau ergibt, bei welchem Einschubwände in unterschiedlicher Größe verwendet oder auch für besseren Zugriff auf den Innenraum nicht eingesetzt bzw. schnell entfernt werden können.

In einer Ausführung ist vorgesehen, dass die mindestens eine Ecksäule einen Außenmantel in Form eines Teil-Hohlzylinders mit einem Dreiviertelkreisquerschnitt aufweist, wobei der Außenmantel der mindestens einen Ecksäule die Schnittstelle für externe Halterungen ist. Dies ist vorteilhaft, da durch diesen Aufbau einerseits Gewicht eingespart und andererseits ein kompakter Aufbau ermöglich werden kann.

In einer weiteren Ausführung weist das Gehäusesystem weiterhin mindestens eine externe Halterung auf, wobei die mindestens eine externe Halterung mindestens einen Klemmabschnitt mit einem halbkreisförmigen Querschnitt aufweist, dessen Innenradius mit dem Außenradius des Außenmantels als Schnittstelle für externe Halterungen der mindestens einen Ecksäule korrespondiert. Damit eignen sich die Ecksäulen vorteilhaft für einfaches und schnelles Anbringen, Wechseln und Lösen von externen Halterungen mit entsprechenden Klemmeinrichtungen. Besonders vorteilhaft ist dabei, dass dazu kein Werkzeug erforderlich ist.

Eine noch weitere Ausführung sieht vor, dass in dem Außenmantel der mindestens einen Ecksäule eine Innensäule mit einer zentralen Durchgangsöffnung angeordnet ist. Dies spart vorteilhaft Platz und Gewicht.

Wenn die Durchgangsöffnung der Innensäule als Innensechskantquerschnitt ausgebildet ist, kann vorteilhaft eine handelsübliche Verschraubung mit Sechskantschrauben und -muttern eingesetzt werden.

In einer anderen Ausführung ist an der Innensäule eine sich längs der Innensäule erstreckende Kanalwand mit einem Kanal angeordnet. Dieser Aufbau bietet eine vorteilhafte Stabilität und zusätzlichen Raum an der Ecksäule, z.B. für weitere Verschlussmechanismen des Gehäuses.

Es ist zudem besonders vorteilhaft, wenn auf jeder Seite der Kanalwand ein Halteabschnitt durch eine Verlängerung der an der Ecksäule angebrachten Seitenwand, die Kanalwand und einen an der Seitenwand angebrachten Steg festgelegt ist, wobei diese beiden Halteabschnitte eine Einsatzaufnahme als Schnittstelle für interne Halterungen bilden. Die Ecksäule(n) weist (weisen) so weitere Funktionalität bei kompaktem Aufbau auf.

In einer weiteren Ausführung ist vorgesehen, dass die Einsatzaufnahme weiterhin einen in Längsrichtung der Kanalwand an diesem befestigten Steg aufweist, welcher eine Trennung der beiden Halteabschnitte in Längsrichtung bildet. Dies ermöglicht vorteilhaft eine größere Stabilität der Ecksäule.

Wenn die beiden Halteabschnitte in einer Querrichtung durch einen Quersteg geteilt sind und zwei Einsatzaufnahmen bilden, wobei die Einsatzaufnahme jeweils zu einem Innenraum des zugehörigen Rahmens hin geöffnet sind, wobei die jeweilige Öffnung durch die Stege, den Steg und den Quersteg festgelegt ist, und wobei die Einsatzaufnahme die Schnittstelle für interne Halterungen der mindestens einen Ecksäule bildet, können die Schnittstellen auf diese Weise einfache Festlegungen der einzusetzenden internen Halterung vorteilhaft bilden.

Es ist in einer noch weiteren Ausführung vorgesehen, dass das Gehäusesystem weiterhin mindestens eine interne Halterung aufweist, wobei die mindestens eine interne Halterung eine Halteeinrichtung aufweist, deren Form für einen formschlüssigen Eingriff mit der Form der Einsatzaufnahme als Schnittstelle für interne Halterungen der mindestens einen Ecksäule korrespondiert. Damit kann eine besonders einfache und schnelle Montage vorteilhaft ermöglicht werden.

Die Halteeinrichtung kann stegförmige Vorsprünge oder/und vorgespannte Federstege aufweisen, welche die Halteeinrichtung in den Halteabschnitten formschlüssig und durch Reibkraft kraftschlüssig festlegen. Das ist vorteilhaft für einen einfachen und kompakten Zusammenbau.

In einer Ausführung kann das Gehäuse mit Befestigungselementen, vorzugsweise Schrauben und Muttern, welche in der Durchgangsöffnung der Innensäule der mindestens einen Ecksäule angeordnet sind, zusammengehalten sein.

Für einen besonders vorteilhaft einfachen und schnellen Zusammenbau kann das Gehäuse mit Magneten, die als Permanentmagneten Magnetverschlüsse bilden, zusammengehalten sein. Auf diese Weise lässt sich das Gehäuse natürlich auch einfach und schnell öffnen und wieder schließen. Das ist besonders bei Versuchsaufbauten und Erweiterungen von großem Vorteil.

In einer weiteren Ausführung sind die Magneten der Magnetverschlüsse in den Eingängen der Durchgangsöffnung der Innensäule der mindestens einen Ecksäule und in Aufnahmen in den Deckeln angeordnet. Dies ist besonders vorteilhaft, da es einen kompakten Aufbau ergibt. Die Magneten können eingeklebt oder/und eingeklemmt werden.

In einer Ausführung weisen die Deckel Säulenabdeckungen auf, welche die Ecksäulen verschließen. Damit wird ein vorteilhaft kompakter Aufbau erzielt, wobei auch gleichzeitig die in den Halteabschnitten der Ecksäulen angeordneten internen Halterungen zusätzlich fixiert sind.

Es ergeben sich folgende Vorteile:
- Vergrößerungsmöglichkeiten des Gehäuses durch Zusatzrahmen für größere Einbauten (Lüfter, Zusatzplatinen, gesteckte Zusatzplatinen, Netzteil)
- Tragschienenhalterung
- Interne Klemmleisten
- Steckverbinder (z.B. für Bedienungen, Sensoren, Aktoren)
- Geschlossenes Gehäuse (Kunststoff, Metall oder Kombinationen)
- Frei zugängliche Anschlüsse (z.B. durch Einschubwände)
- Kompaktes, robustes und schlankes Gehäuse
- Aufnahme von Experimentierplatinen
- Anschlüsse an verschiedenen Seiten, oben, unten
- Geringe Kosten
- Verschiedenen IP-Schutzarten möglich (z.B. IP34)
- Einfache Montage und Demontage
- Integrierte Halterungen (z.B. für Kamera, Display, Bedienung etc.)
- Kabelöffnungen und Kabelbündelung

Ausführungsbeispiele der Erfindung werden nachfolgend anhand der beigefügten Zeichnungen beschrieben. Diese Ausführungsbeispiele dienen lediglich der Veranschaulichung der Erfindung anhand bevorzugter Konstruktionen, welche aber die Erfindung nicht abschließend darstellen. Es sind insofern im Rahmen der Ansprüche auch andere Ausführungsbeispiele sowie Modifikationen und Äquivalente der dargestellten Ausführungsbeispiele realisierbar.

Es zeigen:
- Fig. 1: eine schematische Perspektivansicht eines Ausführungsbeispiels eines erfindungsgemäßen Gehäuses;
- Fig. 2: eine schematische perspektivische Innenansicht des Gehäuses nach Fig. 1;
- Fig. 3: eine schematische, vergrößerte Perspektivansicht von Einsatzbereichen einer Ecksäule auf der Innenseite des Gehäuses nach Fig. 1;
- Fig. 4: eine schematische Perspektivansicht eines zweiten Ausführungsbeispiels des erfindungsgemäßen Gehäuses nach Fig. 1;
- Fig. 5: eine schematische Explosionsansicht des zweiten Ausführungsbeispiels des erfindungsgemäßen Gehäuses nach Fig. 4;
- Fig. 6: eine schematische Schnittansicht von Ecksäulen des zweiten Ausführungsbeispiels nach Fig. 4;
- Fig. 7-8: schematische Perspektivansichten des zweiten Ausführungsbeispiels nach Fig. 4 mit externen Zubehörhaltern;
- Fig. 9-10: schematische Perspektivansichten externer Zubehörhalter nach Fig. 7-8;
- Fig. 11-12: schematische perspektivische Innenansichten von Ecksäulen mit internen Zubehörhaltern;
- Fig. 13-16: schematische Perspektivansichten von internen Zubehörhaltern, und
- Fig. 17: eine schematische Schnittansicht einer Variante des Gehäuses.

Die Begriffe "oben", "unten", "links", "rechts" beziehen sich auf die jeweilige Anordnung der Bauteile in den Figuren.

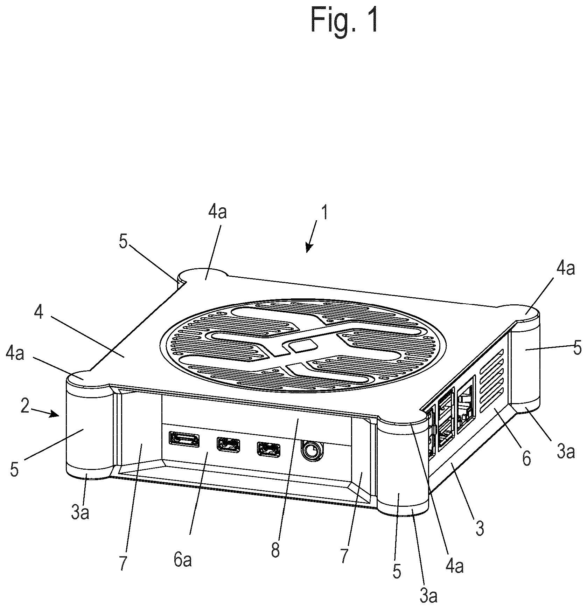

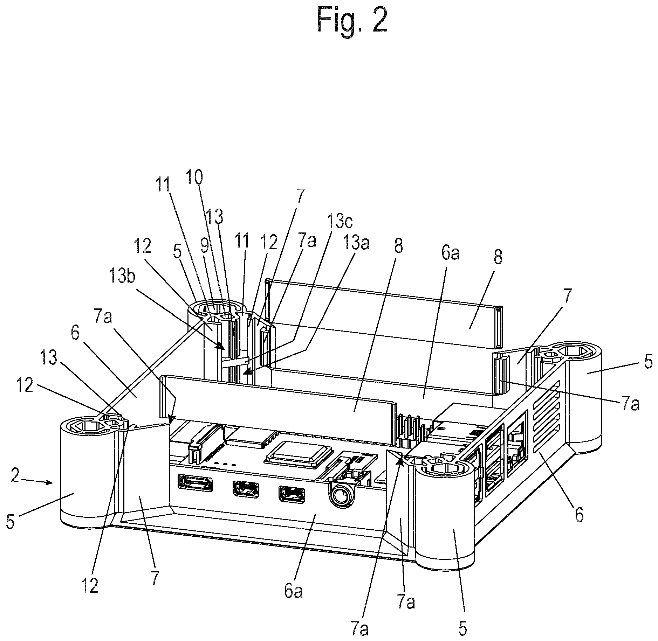

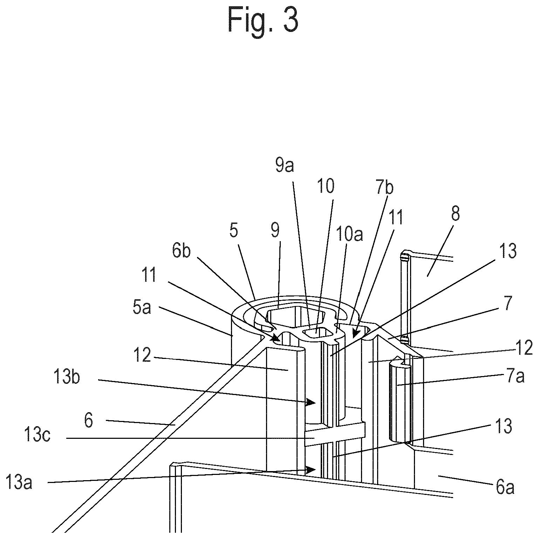

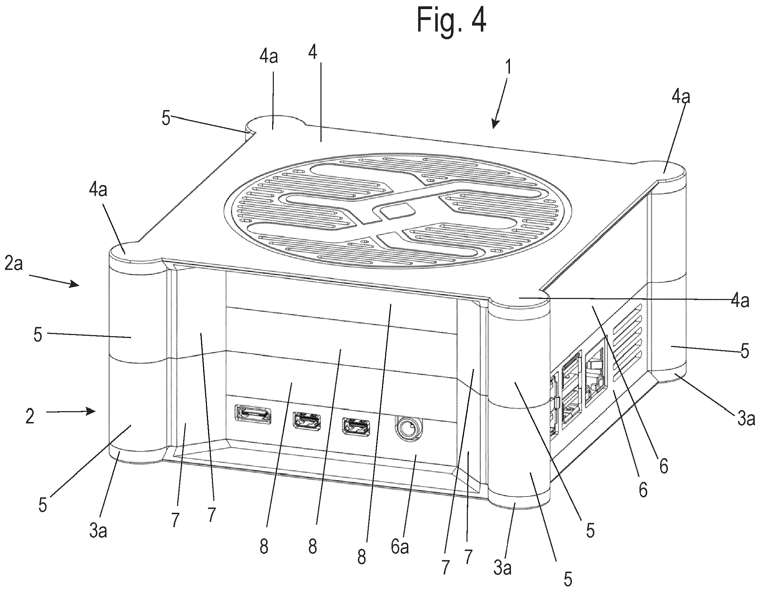

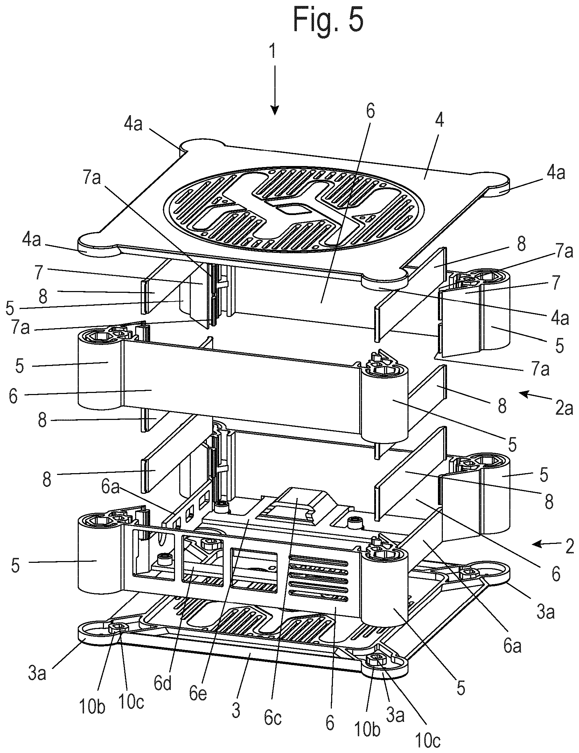

In Fig. 1 ist eine schematische Perspektivansicht eines Ausführungsbeispiels eines erfindungsgemäßen Gehäuses 1 dargestellt. Fig. 2 zeigt dazu eine schematische perspektivische Innenansicht des Gehäuses 1 nach Fig. 1. Fig. 3 zeigt eine schematische, vergrößerte Perspektivansicht von Einsatzaufnahmen 13a, 13b einer Ecksäule 5 auf der Innenseite des Gehäuses 1 nach Fig. 1. Fig. 4 stellt eine schematische Perspektivansicht eines zweiten Ausführungsbeispiels des erfindungsgemäßen Gehäuses 1 nach Fig. 1 dar. In Fig. 5 ist eine schematische Explosionsansicht des zweiten Ausführungsbeispiels des erfindungsgemäßen Gehäuses 1 nach Fig. 4 gezeigt.

Das Gehäuse 1 dient zur Aufnahme von eines oder mehrerer so genannter Einplatinencomputer (Single Board Computer - SBC) mit elektrischen Versorgungseinheiten (z.B. Netzteil, Batterie usw.), Lüftern, Anschlüssen für Tastatur, Drucker, Sensoren, Aktoren usw. z.B. mittels Steckverbinder u.dgl., Zusatzplatinen und weiteres.

Das Gehäuse 1 des ersten Ausführungsbeispiels umfasst einen Grundrahmen 2, einen Bodendeckel 3, einen Deckel 4, feste Seitenwände 6, 6a und Einschubwände 8. Die Einschubwände 8 können in bestimmter Verwendung des Gehäuses 1 auch weggelassen bzw. entnommen werden, um Zugriff auf eingebaute Teile/Systeme zu erhalten.

Die Einschubwände können selbstverständlich auch vom Kunden noch mechanisch bearbeitet werden. So können beispielsweise weitere Bohrungen oder/und Aussparungen für Anschlüsse, Kabeleinführungen, Anzeigen u.dgl. eingebracht werden.

Das Gehäuse 1 ist Teil eines Gehäusesystems, welches zudem interne Halterungen und externe Halterungen sowie Befestigungselemente, Verbindungsschrauben etc. umfasst.

Eine Grundfläche des Gehäuses 1 ist in einem Beispiel so bemessen, dass Leiterplatten im Europakartenformat von 100 mm x 160 mm eingebaut werden können.

In einer Ausführung ist das Gehäuse 1 z.B. quadratisch.

Die Gestalt des Gehäuses 1 ist rechteckig, wobei mindestens eine Ecke des Gehäuses 1 als Ecksäule 5 ausgebildet ist. In dem gezeigten Beispiel ist jede Ecke mit einer Ecksäule 5 versehen. Der Grundrahmen 2 ist derart aufgebaut, dass die Ecksäulen 5 mit den festen Seitenwänden 6, 6a untereinander verbunden sind. Dabei stehen sich zwei feste Seitenwände 6, welche der Höhe der Ecksäulen 5 entsprechen, gegenüber.

Die festen Seitenwände 6a mit einer halben Höhe der Ecksäulen 5 sind ebenfalls sich gegenüberstehend angeordnet, aber zum Inneren des Grundrahmens 2 hin versetzt und jeweils an jeder Seite über kurze Haltewände 7 mit den zugehörigen Ecksäulen 5 verbunden. Die Haltewände 7 verlaufen dazu in einem Winkel von einer gedachten geraden Verbindungslinie der Ecksäulen 5 zum Inneren des Grundrahmens 2 hin.

Oberhalb der Seitenwände 6a ist hier jeweils eine Einschubwand 8 zwischen den Haltewänden 7 eingesetzt. Die Einschubwände 8 sind mit ihren Seiten in Haltewinkel 7a an den Innenseiten der Haltewände 7 eingeschoben und durch diese gehalten. Dies ist in Fig. 2 verdeutlicht.

In der festen Seitenwand 6a, die in Fig. 1 im Vordergrund gezeigt ist, sind unterschiedliche Anschlüsse, z.B. HDMI-, USB-, Klinkensteckanschlüsse, angeordnet. Auch eine der anderen Seitenwände 6, in Fig. 1 auf der rechten Seite, ist mit verschiedenen Anschlüssen versehen. Diese Anschlüsse können sich auf einer Leiterplatte im Inneren des Gehäuses 1 befinden, wobei dazu passenden Durchbrüche in der Seitenwand 6, 6a eingeformt sind. Die Anschlüsse können auch als separate Steckverbindungen in der betreffenden Seitenwand 6, 6a eingebaut sein, die dafür die passenden Öffnungen aufweist.

Der Grundrahmen 2 ist an seiner Unterseite durch den Bodendeckel 3 verschlossen. Auf der Oberseite des Grundrahmens 2 ist der Deckel 4 aufgesetzt. Sowohl der Bodendeckel 3 als auch der Deckel 4 verschließen die Ober- und Unterseiten der Ecksäulen 5 mit zu der Form der Ecksäulen 5 passenden Säulenabdeckungen 3a, 4a. Die Säulenabdeckungen 3a, 4a sind hier einstückig mit dem jeweiligen Deckel 3, 4 ausgebildet.

Der Aufbau der Ecksäulen 5 ist hier identisch. Sie weisen jeweils einen Außenmantel 5a in Form eines Teil-Hohlzylinders mit einem Dreiviertelkreisquerschnitt auf. An jeder Seite dieses Außenmantels 5a ist jeweils eine der Seitenwände 6, 6a bzw. der Haltewände 7 angebracht.

Der im Folgenden beschriebene Aufbau einer Ecksäule 5 gilt für alle Ecksäulen 5. Dieser Aufbau ist in der vergrößerten Ansicht in Fig. 3 deutlich dargestellt.

In dem Außenmantel 5a ist konzentrisch zu dem Teil-Hohlzylinder eine Innensäule 9 angeordnet. Die Innensäule 9 weist hier einen Sechskantaußenquerschnitt und eine zentrale Durchgangsöffnung in Richtung der Längsachse der Innensäule auf. Diese Durchgangsöffnung ist als Innensechskantquerschnitt ausgebildet.

Die Innensäule 9 ist so angeordnet, dass ein sich in Richtung der Hohlzylinderachse erstreckendes Flächensegment 9a zwischen den Enden des Außenmantels 5a der Ecksäule 5 angeordnet ist und eine Flächennormale dieses Flächensegmentes 9a in Richtung einer Diagonalen bzw. einer gedachten Verbindungslinie der Mittelpunkte der diagonal gegenüberliegenden Ecksäule 5 verläuft.

An dem Flächensegment 9a der Innensäule 9 ist ein sich in Längsrichtung der Innensäule 9 erstreckender Kanal 10 in einer Kanalwand 10a angeordnet. Der Kanal 10 ist von der ihn umgebenden Kanalwand 10a und dem Flächensegment 9a der Innensäule 9 festgelegt. Der Kanal 10 weist hier einen viereckigen, insbesondere quadratischen Querschnitt auf und ist durchgehend.

Ein sich in Längsrichtung der Kanalwand 10a erstreckender Steg 13 ist an dem Abschnitt der Kanalwand 10a angeformt, welcher parallel zu dem Flächensegment 9a verläuft.

Der Steg 13 steht von der Kanalwand 10a in Richtung der oben beschriebenen Diagonalen bzw. Flächennormalen hervor. Der Steg 13 verläuft an der Kanalwand 10a in der gesamten Länge bzw. Höhe der Ecksäule 5 und ist auf halber Länge mit einem Quersteg 13c verbunden.

Die Innensäule 9 ist zudem in der Öffnung zwischen den Enden des Außenmantels 5a mit diesen beiden Enden über eine jeweilige seitliche Verlängerung 6b, 7b der Seitenwand 6 und der Haltewand 7 verbunden.

Gegenüber den beiden Seiten der Kanalwand 10a, die rechtwinklig zu dem Flächensegment 9a der Innensäule 9 an diesem angebracht sind, ist jeweils Steg 12 an einer Innenseite der Seitenwand 6 und der Haltewand 7 angeordnet. Diese Stege 12 stehen von der Innenseite der Wände 6 und 7 um einen bestimmten Winkel zu der jeweiligen Wand 6, 7 geneigt in den Innenraum des Grundrahmens 2 hervor. In einer jeweiligen gedachten Verlängerung dieser Stege 2 in den Innenraum des Grundrahmens 2 hinein schneiden sich diese gedachten Verlängerungen in einem Winkel, der hier 90° beträgt.

Der Quersteg 13c ist mit den Kanten der Stege 12 verbunden. Eine Länge der Stege 12 entspricht einer Länge der zugehörigen Ecksäule 5.

Auf diese Weise wird auf jeder Seite der Kanalwand 10a ein Halteabschnitt 11 durch die Verlängerung 6b, 7b, die Kanalwand 10a und den Steg 12 festgelegt. Diese beiden Halteabschnitte 11 sind symmetrisch zueinander längs einer Symmetrieachse, die in dem Steg 13 verläuft. Der Steg 13 bildet eine Trennung dieser beiden Halteabschnitte 11 in Längsrichtung. Beide Halteabschnitte 11 sind in ihrer Längsrichtung nach oben und unten offen.

Ein Quersteg 13c teilt diese beiden Halbabschnitte 11 in zwei obere und zwei untere Halbabschnitte 11. Die beiden oberen Halteabschnitte 11 bilden eine obere Einsatzaufnahme 13b. Unterhalb des Querstegs 13c bilden die beiden unteren Halteabschnitte 11 eine untere Einsatzaufnahme 13a.

Die Einsatzaufnahmen 13a und 13b sind jeweils zum Innenraum des Grundrahmens 2 hin geöffnet, wobei die jeweilige Öffnung durch die Stege 12, den Steg 13 und den Quersteg 13c festgelegt ist.

Es ist natürlich auch möglich, dass der Quersteg 13c nicht vorhanden ist. In diesem Fall bilden die Einsatzaufnahmen 13a und 13b eine gemeinsam Einsatzaufnahme. Dies ist hier nicht gezeigt, aber leicht verständlich.

Die Einsatzaufnahmen 13a, 13b sind an jeder Ecksäule 5 ausgebildet. Sie bilden eine Schnittstelle für interne Halterungen bzw. Zubehörhalter, die weiter unten noch beschrieben werden.

In dem zweiten Ausführungsbeispiel nach Fig. 4 umfasst das Gehäuse 1 den Grundrahmen 2 und einen Zusatzrahmen 2a mit festen Seitenwänden 6 und Einschubwänden 8. In weiterer Ausgestaltung kann das Gehäuse 1 natürlich auch mehr als einen Zusatzrahmen 2a aufweisen.

Der Zusatzrahmen 2a ist derart auf dem Grundrahmen 2 aufgesetzt, dass die Ecksäulen 5 des Zusatzrahmens 2a und des Grundrahmens 2 koaxial übereinander angeordnet sind.

Der Zusatzrahmen 2a unterscheidet sich hier von dem Grundrahmen 2 darin, dass er nur zwei feste Seitenwände 6 aufweist, die gegenüber stehend angeordnet sind. Die anderen Seiten weisen in diesem Beispiel jeweils zwei übereinander liegende Einsatzwände 8 auf. Die Einsatzwände 8 stehen in Verbindung mit den Haltewänden 7, wie im ersten Ausführungsbeispiel beschreiben. So besteht der Zusatzrahmen 2a im Unterschied zum Grundrahmen 2 aus zwei, jeweils mit zwei Ecksäulen 5 fest verbundenen festen Seitenwänden 6.

In Fig. 5 ist der Bodendeckel 3 von seiner Innenseite gesehen dargestellt. Ein SD-Kartenschacht auf einer im Inneren des Gehäuses 1 angeordneten Leiterplatte kann z.B. nach Entfernung des Bodendeckels 3 oder des Deckels 4 zugänglich sein. Hierbei kann eine Wanne 6c unter dem Kartenschacht vorgesehen sein, die ein Hineinfallen einer SD-Karte in das Gehäuse 1 verhindert.

Die Wanne 6c ist auf einem Plattenelement 6d angeordnet, welches zwischen den festen Seitenwänden 6a vor der in Fig. 5 hinten liegenden festen Seitenwand 6 in nicht näher beschriebener Weise befestigt ist. Ein weiteres Plattenelement 6e ist parallel zu der im Bild vorne liegenden festen Seitenwand 6 angeordnet. Auf diesen Plattenelementen 6d, 6e sind Schraubdome zum Anschrauben von Zubehör und Leiterplatten angeordnet. Derartige Schraubdome können natürlich auch an den Seitenwänden 6, 6a, Einschubwänden 8 oder/und Deckeln 3, 4 angebracht sein.

Im Bereich der Säulenabdeckungen 3a sind zu dem Kanal 10 und der Kanalwand 10a mit deren Form korrespondierende Aufnahmen 10c angeformt. Die Aufnahmen 10c werden unten noch weiter beschrieben.

Eine Verbindung von Grundrahmen 2 und Zusatzrahmen 2a untereinander kann mittels Verschraubungen in den Ecksäulen erfolgen. Für den Bodendeckel 3 und den Deckel 4 gibt es verschiedene Befestigungen, die einzeln oder auch in Kombination möglich sind.

Eine Möglichkeit für einen schnellen Zusammenbau und gleichzeitig festen Halt von Grundrahmen 2, Zusatzrahmen 2a, Bodendeckel 3 und Deckel 4 des Gehäuses 1 bieten Magnetverschlüsse. Diese sind auch einfach zu demontieren.

Bodendeckel 3 und/oder Deckel 4 können auch mit den Rahmen 2, 2a verschraubt werden. Dazu können übliche Schrauben oder/und auch Schnellverschlusselemente wie beispielsweise Renk- oder Bajonettverbindungen verwendet werden.

In einer anderen, nicht gezeigten, aber leicht vorstellbaren Weise können der Bodendeckel 3 und/oder der Deckel 4 aufklemmbar ausgeführt sein. Sie sind dann auch relativ leicht abzunehmen und wieder zu montieren.

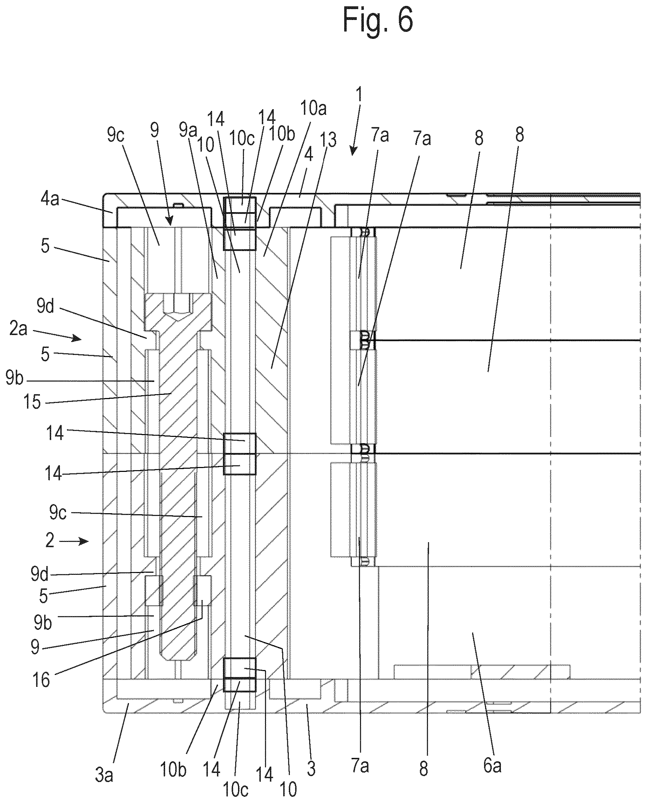

Beispielhafte Verbindungsarten werden nun im Zusammenhang mit Fig. 6 beschrieben.

Fig. 6 zeigt dazu eine schematische Schnittansicht von Ecksäulen 5 des zweiten Ausführungsbeispiels des Gehäuses 1 nach Fig. 4 mit einer festen Seitenwand 6 und drei Einsatzwänden 8.

In Fig. 6 sind sowohl eine beispielhafte Verschraubung als auch beispielhafte Magnetverschlüsse dargestellt, welche einzeln für sich oder auch zusammen verwendet werden können. Beispielsweise kann eine Verschraubung von Grundrahmen 2 und Zusatzrahmen 2b vorgesehen sein, wobei der Bodendeckel 3 und der Deckel 4 mit Magnetverschlüssen versehen sind.

Die Durchgangsöffnungen einer jeden Innensäule 9 weisen jeweils zwei Innensäulenabschnitte 9b und 9c auf, welche mittels eines Bundes 9d in zwei gleich große Innensäulenabschnitte 9b, 9c geteilt sind. Der Bund 9d ist als Ring mit einer Durchgangsbohrung versehen.

Befestigungselemente 15 und 16, hier als Schraube mit einem Sechskantkopf und Sechskantmutter ausgebildet, sind in den Innensäulen 9 angeordnet. Die Schraube und erstreckt sich durch die Durchgangsbohrungen des Bundes 9d der oberen Ecksäule 5 des Zusatzrahmens 2a und des Bundes 9d der unteren Ecksäule 5 des Grundrahmens 2. Die Abmessungen des Sechskantkopfes der Schraube und der Sechskantmutter korrespondieren mit den Abmessungen des Innensechskantes der Innensäule 9. Der Schraubenkopf liegt auf dem Bund 9d der Innensäule 9 des Zusatzrahmens 2a als Widerlager auf. Der untere Bund 9d der Innensäule 9 des Grundrahmens 2 dient als Widerlager für die Sechskantmutter. Die Sechskantmutter wird bei Montage zunächst in den unteren Innensäulenabschnitt 9b der Ecksäule 5 des Grundrahmens 2 eingeschoben. Durch Drehen der Schraube kommt die Sechskantmutter mit dem Gewinde der Schraube in Eingriff und wird dann bei weiterem Drehen der Schraube gegen den unteren Bund 9d der Innensäule 9 der unteren Ecksäule 5 des Grundrahmens 2 festgezogen. Der Innensechskantquerschnitt der Innensäulenabschnitte 9b, 9c bildet eine Verdrehsicherung der Sechskantschraube und der Sechskantmutter beim Zusammenschrauben und Lösen.

Auf diese Weise werden auch die Schraubverbindungen der anderen Ecksäulen 5 des Gehäuse 1 hergestellt.

In einer nicht gezeigten Alternative können zwei Schrauben und eine Langmutter zur Anwendung kommen. Die Langmutter ist dabei in dem unteren Innensäulenabschnitt 9b der oberen Innensäule 9 der Ecksäule 5 des Zusatzrahmens 2a und in dem oberen Innensäulenabschnitt 9c der unteren Innensäule 9 der Ecksäule 5 des Grundrahmens 2 angeordnet. Eine erste Schraube ist von oben durch den oberen Innensäulenabschnitt 9c der oberen Innensäule 9 durch den Bund 9d in die Langmutter eingeschraubt. Eine zweite Schraube ist von unten durch den unteren Innensäulenabschnitt 9b der unteren Innensäule 9 durch den Bund 9d in die Langmutter eingeschraubt. Dies ist nicht gezeigt, aber in Zusammenschau mit Fig. 6 leicht vorstellbar.

Eine weitere, nicht gezeigte Alternative verwendet nur eine lange Schraube und Mutter als Befestigungselemente 15, 16. Die Schraube erstreckt sich durch nicht gezeigte, aber leicht vorstellbare Bohrungen der Säulenabdeckungen 4a und 3a der Deckel 3, 4 und die Bunde 9d. Die Säulenabdeckungen 4a und 3a bilden dabei die Widerlager für Schraube und Mutter. Zwischen Schraubenkopf und Deckel 4 bzw. Mutter und Bodendeckel 3 (oder auch umgekehrt) können Unterlegscheiben angeordnet sein. In dieser weiteren Alternative sind Sechskantschrauben nicht zwingend erforderlich.

Die Magnetverschlüsse weisen Magneten 14 als Permanentmagneten, z.B. Neodym-Magnete, auf. Zur Befestigung des Bodendeckels 3 ist ein Magnet 14 in der unteren Öffnung des Kanals 10 des Grundrahmens 2 befestigt. Ein weiterer Magnet 14 dieses Magnetverschlusses befindet sich in der Aufnahme 10c der Kanalabdeckung 10b in der Säulenabdeckung 3a des Bodendeckels 3. Auf diese Weise sind vier Magnetverschlüsse für den Bodendeckel 3 angeordnet.

Die Magneten 14 sind beispielsweise in ihren Positionen festgeklebt oder geklemmt. In dem Kanal 10 kann zwischen den Magneten 14 auch ein Abstandhalter, z.B. in Form eines Stabs o.dgl., angeordnet sein. Anstelle eines durchgehenden Kanals 10 kann auch nur jeweils eine für den Magneten 14 passende Öffnung an den Kanaleingängen eingeformt sein. Dies kann jedoch das Gesamtgewicht des Gehäuses 1 und den Materialpreis erhöhen.

Natürlich kann die Ecksäule 5 auch aus Vollmaterial erstellt sein, in welches die Durchgangsöffnung mit dem Innensechskantquerschnitt und der Kanal 10 eingeformt sind. Auch diese nicht gezeigte aber vorstellbare Ausführung ist denkbar, jedoch werden dadurch ein Gesamtgewicht des Gehäuses 1 und der Materialpreis erhöht.

Im verschlossenen Zustand liegt der Bodendeckel 3 auf der Unterseite des Grundrahmens 2 so auf, dass sich die Magneten 14 gegenseitig anziehen und eine schnelle Verbindung beim Zusammenbau bieten, die in Abhängigkeit von der Stärke der Magneten 14 eine relativ feste Verbindung bildet.

Die Magnetverschlüsse des Deckels 4 sind ebenfalls in dieser Weise gebildet.

Zwischen Grundrahmen 2 und Zusatzrahmen 2a sind die Magnetverschlüsse ähnlich ausgeführt. In der unteren Öffnung des Kanals 10 des Zusatzrahmens 2a und in der oberen Öffnung des Kanals 10 des Grundrahmens 2 ist jeweils ein Magnet 14 befestigt. Vier dieser Magnetverschlüsse ermöglichen einen festen Zusammenhalt von Grundrahmen 2 und Zusatzrahmen 2a im zusammengebauten Zustand des Gehäuses 1.

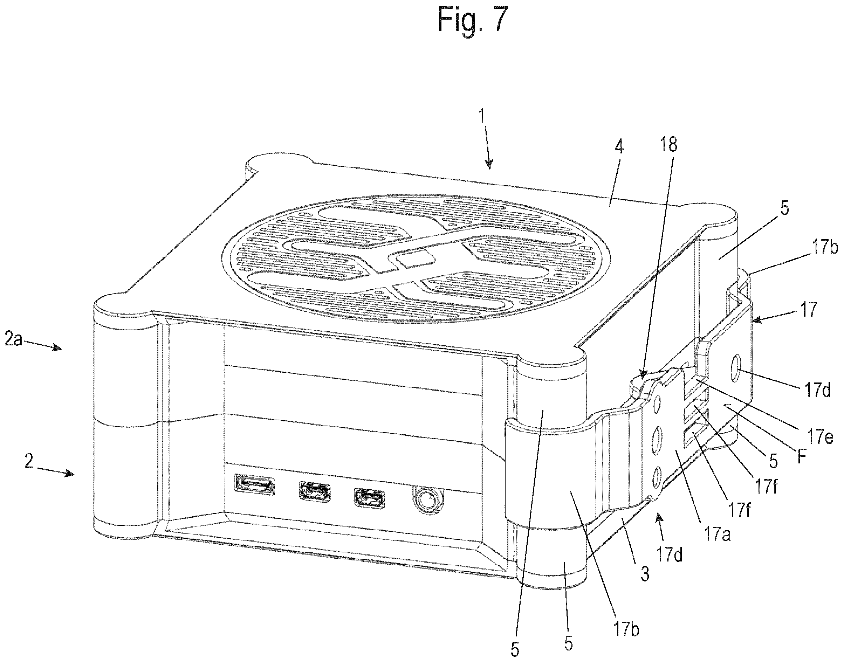

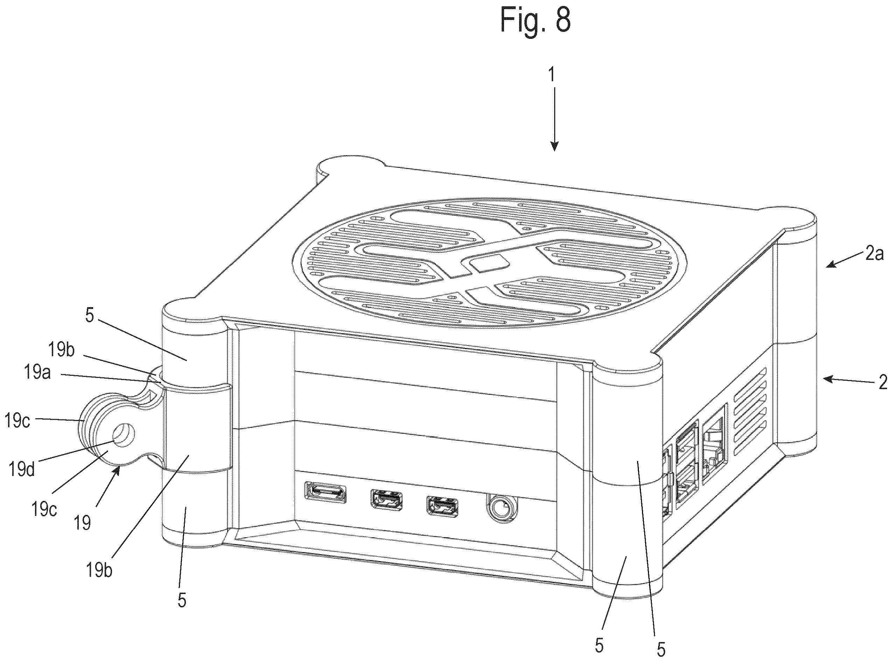

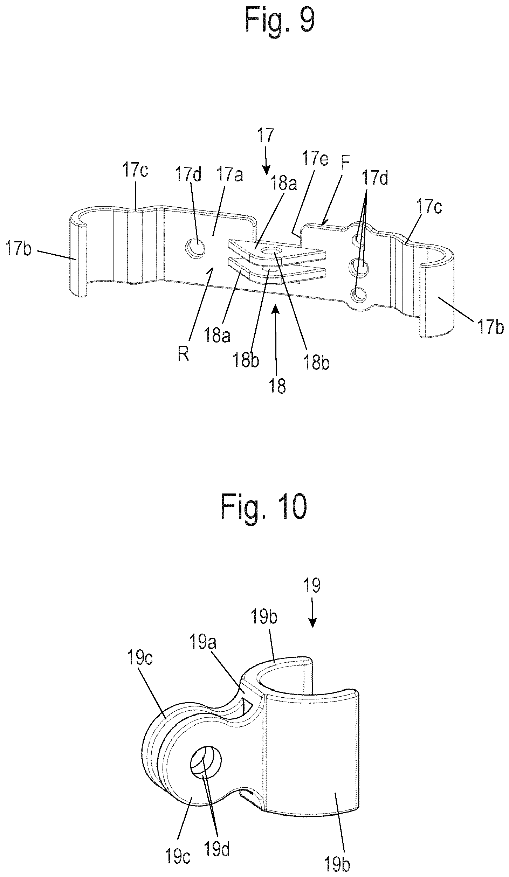

In Fig. 7-8 sind schematische Perspektivansichten des zweiten Ausführungsbeispiels nach Fig. 4 mit externen Zubehörhaltern gezeigt. Fig. 7 zeigt eine schematische Perspektivansicht des zweiten Ausführungsbeispiels des Gehäuses 1 nach Fig. 4 mit einem Befestigungsbügel 17 zur Befestigung des Gehäuses 1 an verschiedenen Orten. In Fig. 8 ist das Gehäuse 1 mit einem Halter 19 für Befestigung von Zubehör an dem Gehäuse 1 dargestellt. In Fig. 9 ist eine schematische Perspektivansicht des externen Zubehörhalters Befestigungsbügel 17 nach Fig. 6-7 gezeigt. Fig. 10 stellt eine schematische Perspektivansicht des externen Zubehörhalters Halter 19 dar.

Der Befestigungsbügel 17 ermöglicht es, das Gehäuse 1 sowohl nur mit dem Grundrahmen 2 als auch mit Grundrahmen 2 und Zusatzrahmen 2a, wie es Fig. 7 zeigt, an verschiedenen Orten zu befestigen.

Der Befestigungsbügel 17 kann in einfacher Weise an dem Gehäuse 1 angebracht werden. Dazu ist kein Werkzeug erforderlich. Ebenfalls ist ein Entfernen des Befestigungsbügels 17 einfach möglich.

Dazu umfasst der Befestigungsbügel 17 eine Basisplatte 17a, zwei Klemmabschnitte 17b und eine Halterung 18.

Die Basisplatte 17a ist im Wesentlichen eine rechteckige Platte, an deren Enden jeweils ein Klemmabschnitt 17b über eine jeweilige, hier gekröpfte Verbindung 17c federnd angebracht ist. Die Klemmabschnitte 17b weisen einen halbkreisförmigen Querschnitt auf, dessen Innenradius mit dem Außenradius der Ecksäulen 5 korrespondiert. Die Klemmabschnitte 17b sind symmetrisch zueinander angeordnet, wobei ihre kurzen Seitenkanten zu einer Rückseite R des Befestigungsbügels 17 hin aufeinander zugebogen sind.

Der Befestigungsbügel 17 ist mit einer Rückseite R zu dem Gehäuse 1 weisend an diesem über die Klemmabschnitte 17b an den Ecksäulen 5 des Gehäuses 1 angeklipst. Eine Frontseite F des Befestigungsbügels 17 weist nach außen und bildet eine Anlagefläche für an der Basisplatte 17a zu befestigende Teile, z.B. Haltewinkel, Tragschienenhalterungen usw. Dazu ist die Basisplatte 17a mit unterschiedlichen Durchgangsöffnungen 17d für Halteschrauben, -stifte etc. versehen.

In einem mittleren Bereich der Basisplatte 17 ist eine Ausnehmung 17e eingeformt. In diesem Bereich ist an der Rückseite R der Basisplatte 17a die Halterung 18 angebracht. Die Halterung 18 weist zwei parallel zu einander beabstandete Haltebacken 18a mit jeweils einer Durchgangsöffnung 18b auf. Die Durchgangsöffnungen 18b sind hier kreisrunde Löcher und koaxial zueinander angeordnet.

Oberhalb der oberen Haltebacke 18a ist die Ausnehmung 17e angeordnet. Zwischen der oberen Haltebacke 18a und der darunter liegenden unteren Haltebacke 18a, sowie unter der unteren Haltebacke 18a ist jeweils eine rechteckige Öffnung 17f in der Basisplatte 17a eingeformt. Die Ausnehmung 17e und die Öffnungen 17f dienen zum Durchstecken von standardisierten Halterungen von externem Zubehör, wie z.B. Display, Kamera, Schalter, Anzeigeleuchten etc., die an der Halterung 18 mittels entsprechender Rastteile oder/und Klemm-/Rastbolzen mithilfe der Durchgangsöffnungen 18b fixiert werden können.

Die Klemmabschnitte 17b sind untereinander in einem Abstand derart an der Basisplatte 17a des Befestigungsbügels 17 angeordnet, dass ihre gedachten Mittellinien mit dem Abstand der gedachten Mittellinien der Ecksäulen 5 des Gehäuses 1 korrespondieren. Eine Höhe des Befestigungsbügels 17 korrespondiert mit einer Höhe der festen Seitenwände 6 des Grundrahmens 2.

Der Halter 19 zur Befestigung von externem Zubehör, z.B. standardisierte Halterungen für Kameras etc., umfasst eine Basisplatte 19a, einen Klemmabschnitt 19b und Haltebacken 19c mit Durchgangsöffnungen 19d.

Die Basisplatte 19a ist rechteckig und mit dem Klemmabschnitt 19b verbunden. Der Klemmabschnitt 19b weist wie die Klemmabschnitte 17b des Befestigungsbügels 17 einen halbkreisförmigen Querschnitt auf, dessen Innenradius mit dem Außenradius der Ecksäulen 5 korrespondiert.

Auf einer Außenseite des Basisabschnitts 19a sind die Haltebacken 19c in ähnlicher Weise wie die Haltebacken 18a der Halterung 18 in einem Abstand parallel zueinander angeordnet. Die Durchgangsöffnungen 19d sind auch hier kreisrunde Löcher und koaxial zueinander angeordnet.

Mittels des Klemmabschnitts 19b kann der Halter 19 an jeder Position an den Ecksäulen 5 des Gehäuses 1 angeklemmt werden. Ein besonderes Werkzeug ist weder zum Anbringen noch zum Entfernen erforderlich.

Mit anderen Worten, die Ecksäulen 5 bilden Schnittstellen für die externen Halterungen externen Zubehörs, wobei die externen Halterungen hier Befestigungsbügel 17 und Halterungen 18 sein können.

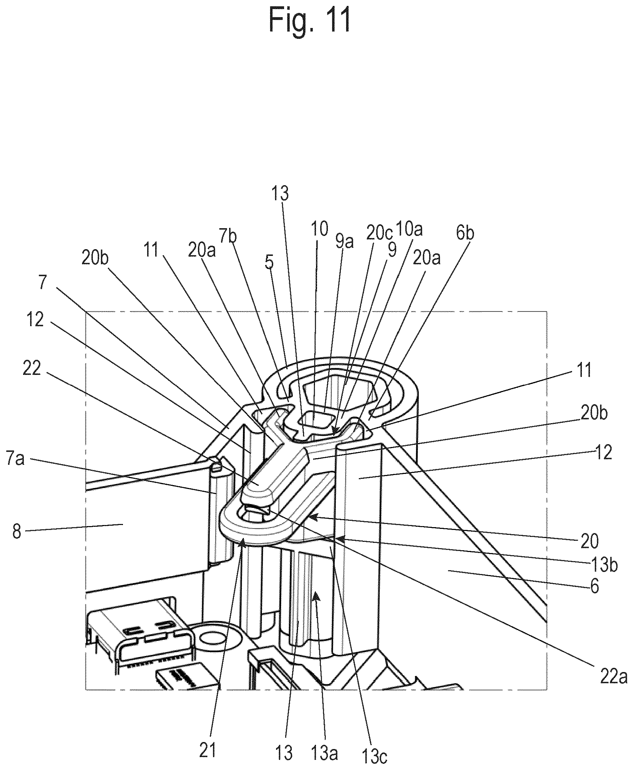

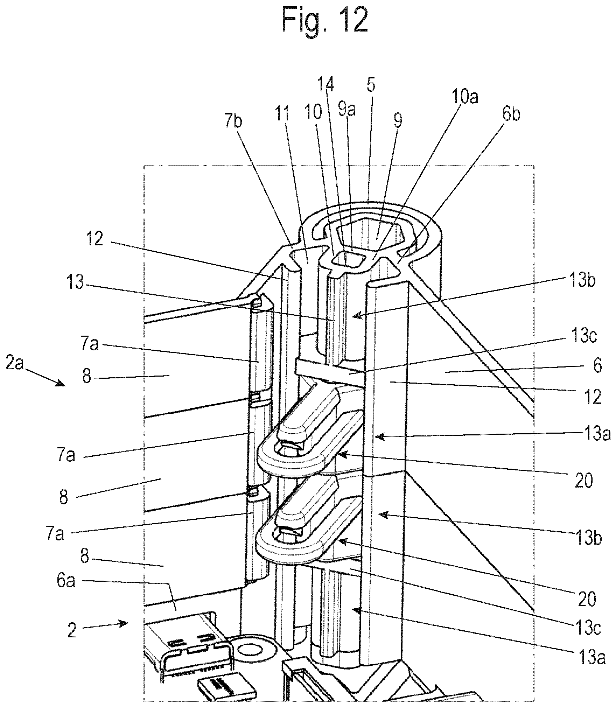

In Fig. 11 und 12 sind schematische perspektivische Innenansichten der Ecksäulen 5 mit internen Zubehörhaltern dargestellt.

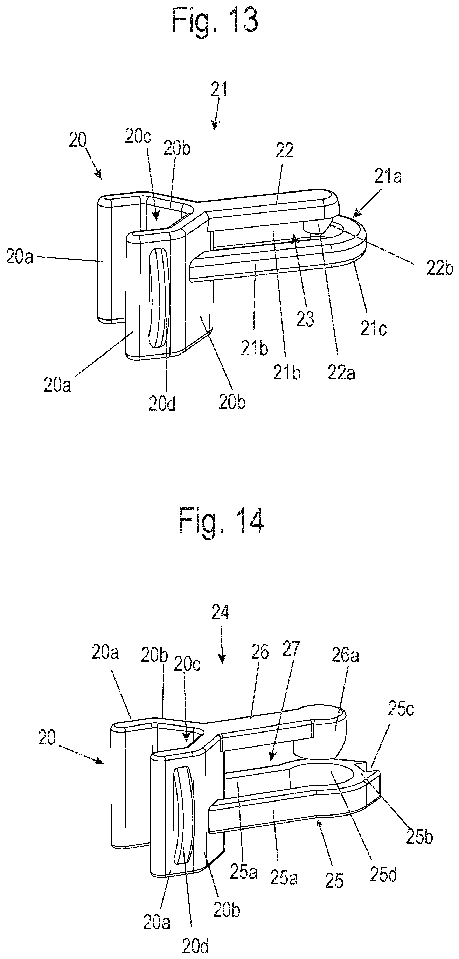

Fig. 11 zeigt einen inneren Eckbereich des Grundrahmens 2 des Gehäuses 1 mit einer Ecksäule 5 und mit einem Halteelement 21. Zwei Halteelemente 21 in dem inneren Eckbereich sowohl im Grundrahmen 2 als auch im Zusatzrahmen 2a stellt Fig. 12 dar. Fig. 13 zeigt eine schematische Perspektivansicht des Halteelementes 21.

Die oben beschriebenen Einsatzaufnahmen 13a und 13b der Ecksäule 5 sind hier vergrößert dargestellt. Die untere Einsatzaufnahme 13a ist frei, in der oberen Einsatzaufnahme 13b ist das Halteelement 21 von oben eingeschoben eingesetzt. Das Halteelement 21 weist eine Halteeinrichtung 20 auf, deren Form für einen formschlüssigen Eingriff mit der Form der Einsatzaufnahme 13a, 13b korrespondiert.

Die Halteeinrichtung 20 umfasst Halteplatten 20a, 20b, eine Aufnahme 20c und stegförmige Vorsprünge 20d (siehe Fig. 13).

Die Halteplatten 20a und die Halteplatten 20b sind als rechteckige Platten ausgebildet. Die Halteplatten 20a sind parallel zueinander angeordnet und weisen freie abgerundete Ecken auf.

An einer jeweiligen Längsseite einer Halteplatte 20a ist jeweils eine weitere Halteplatte 20b in einem Winkel dergestalt angebracht, dass die freien Längsseiten der Halteplatten 20b miteinander verbunden sind

Die Innenflächen der Halteplatten 20a und der Halteplatten 20b bilden zwischen sich die Aufnahme 20c.

An den Außenflächen der Halteplatten 20a ist jeweils ein stegförmiger Vorsprung 20d in Längsrichtung angeordnet. Die stegförmigen Vorsprünge 20d sind an ihren Enden an der jeweiligen Halteplatte 20a befestigt, wobei sie in diesem Beispiel jeweils als Teilkreisstück nach außen von den jeweiligen Außenflächen der Halteplatten 20a hervorstehen. Die stegförmigen Vorsprünge 20d können mit den Halteplatten 20a einstückig ausgebildet und auch im Falle eines Spritzgussteils vollausgespritzt sein

In einer Variante, die hier nicht gezeigt aber leicht vorstellbar ist, können die stegförmigen Vorsprünge 20d als federnde Elemente, z.B. als Federstege, ausgebildet sein. Es ist natürlich auch denkbar, dass sowohl stegförmige Vorsprünge 20d als auch Federstege verwendet werden können.

Diese Halteeinrichtung 20 ist für alle internen Halterungen, die unten weiter noch beschrieben werden, identisch. An der Halteeinrichtung 20 sind dabei jeweils unterschiedliche Halterungen als Bügel, Arme, Klipse usw. angebracht, die von der Halteeinrichtung 20 hervorstehen.

Die Halteeinrichtung 20 und die Einsatzaufnahmen 13a, 13b bilden jeweils eine Schnittstelle zur Anbringung der unterschiedlichen Halterungen. Auf diese Weise können alle internen Halterungen in allen möglichen Positionen innerhalb des Gehäuses 1 in den Einsatzaufnahmen 13a, 13b universell eingesetzt werden.

Im eingesetzten Zustand sind die Halteplatten 20a der Halteeinrichtung 20 in der Einsatzaufnahme 13a, 13b in deren Halteabschnitten 11 seitlich jeweils zwischen dem Steg 12, der Verlängerung 6b, 7b und der Kanalwand 10a und unten bzw. oben durch den Quersteg 13c begrenzt aufgenommen. Dabei stehen die stegförmigen Vorsprünge 20d an den Halteplatten 20a der Halteeinrichtung 20 nach dem Einschieben mit den Wänden der Einsatzaufnahme 13a, 13b in Kontakt. Die stegförmigen Vorsprünge 20d legen auf diese Weise die Halteeinrichtung in den Halteabschnitten durch Reibkraft kraftschlüssig und durch ihre Form formschlüssig fest. Die stegförmigen Vorsprünge 20d können auch mit Übermaß vorstehen.

Die Halteplatten 20b der Halteeinrichtung 20 sind dabei jeweils zwischen dem Steg 12 und dem Steg 13 der Einsatzaufnahme 13a, 13b angeordnet, wobei die Kanalwände 10a und der Längssteg 13 in der Aufnahme 20c der Halteeinrichtung 20 angeordnet sind. Der Steg 13 kontaktiert dabei die Verbindung der Längsseiten der Halteplatten 20b der Halteeinrichtung 20.

Das Halteelement 21 bzw. andere Halterungen kann/können in die Einsatzaufnahme(n) 13a, 13b eingesetzt bzw. eingeschoben werden, wenn das Gehäuse 1 geöffnet ist. Dazu sind die zugehörigen Deckel 3, 4 abzunehmen. Nach Einsatz der Halterung werden die von der Halterung/den Halterungen zu haltenden Teile in die Halterungen eingeschoben, eingeklemmt usw. Wenn das Gehäuse 1 wieder verschlossen ist, ist die Halteeinrichtung 20 der jeweiligen Halterung in der Einsatzaufnahme 13a, 13b durch die Säulenabdeckungen 3a, 4a der Deckel 3, 4 und die Querstege 13c axial fixiert.

Das Halteelement 21 umfasst die Halteeinrichtung 20, einen Bügel 21a und einen Federarm 22. Dies ist in Fig. 13 deutlich dargestellt

Der Bügel 21a ist u-förmig ausgebildet und weist zwei parallele Bügelarme 21b und einen halbkreisförmigen Verbinder 21c auf. Der Verbinder 21c verbindet die Bügelarme 21b an ihren freien Enden. Die anderen Enden der Bügelarme 21b sind an den Außenseiten der schrägen Halteplatten 20b der Halteeinrichtung 20 in einem oberen Drittel der Halteplatten 20b angebracht. Der Bügel 21a liegt mit seiner u-Form in einer Ebene rechtwinklig zu einer gedachten Längsachse der Aufnahme 20c der Halteeinrichtung 20.

Oberhalb des Bügels 21a ist der Federarm 22 in einem oberen Bereich an der Verbindung der schrägen Halteplatten 20b der Halteeinrichtung 20 angebracht. Eine Oberseite des Federarms 22 fluchtet mit der Oberseite der Halteplatten 20a, 20b der Halteeinrichtung 20. Zwischen der Unterseite des Federarms 22 und dem Bügel 21a ist ein Halteraum 23 gebildet. Der Federarm 22 ist in einer Ebene parallel zu der Ebene des Bügels 21a über dem Zwischenraum angeordnet, welcher von den Bügelarmen 21b des Bügels 21a gebildet ist. Dabei ist das freie Ende des Federarms 22 abgerundet. Eine Länge des Federarms 22 entspricht etwa der Länge des Zwischenraums zwischen den Bügelarmen 21b.

An der Unterseite des freien Endes des Federarms 22 ist ein kreiszylinderförmiger Vorsprung 22a angeformt, welcher von der Unterseite des Federarms 22 nach unten hervorsteht und an seiner vorderen Seite, die zu dem freien Ende des Federarms 22 weist, mit einer Fase 22b versehen.

Ein Abstand zwischen dem Federarm 22 und dem Bügel 21a kann der Dicke einer üblichen Leiterplatte oder einer Haltefläche eines zu haltenden Gegenstands entsprechen. Der Vorsprung 22a dient zur Fixierung des zu haltenden Gegenstands, indem der Vorsprung 22a beim Einschieben des Gegenstands zwischen Bügel 21a und Vorsprung 22a aufgrund der Fase 22b mit dem Federarm 22 hochgedrückt wird und in eine für den Vorsprung 22a vorgesehene Einformung des Gegenstands einrastet. Beim Hochdrücken des Federarms 22 wird dieser gespannt und drückt den Vorsprung 22a in die für ihn vorgesehene Einformung mit einer vorbestimmten Kraft hinein.

In den in Fig. 11 und 12 gezeigten eingesetzten Lagen der Halteelemente 21 stehen die Bügel 21a und die Federarme 22 in Richtung einer Diagonalen des Innenraums des Gehäuses 1 in den Innenraum hervor.

In Fig. 12 ist auch ein Magnet 14 in der oberen Öffnung des Kanals 10 gezeigt.

Fig. 12 zeigt zwei übereinander angeordnete Halteelemente 21. Das obere Halteelement 21 ist in der unteren Einsatzaufnahme 13a der Ecksäule 5 des Zusatzrahmens 2a aufgenommen. Das untere Halteelement 21 befindet sich in der oberen Einsatzaufnahme 13b der Ecksäule des Grundrahmens 2.

Die übereinander angeordneten Einsatzaufnahmen 13a des Zusatzrahmens 2a und 13b des Grundrahmens 2 bilden eine gemeinsame Einsatzaufnahme 13a, 13b, welche doppelt so viel Raum aufweist als eine einzelne Einsatzaufnahme 13a, 13b. Wenn nur eine dieser gemeinsamen Einsatzaufnahmen 13a, 13b benötigt wird, kann z.B. ein entsprechender Einsatz in die dabei leer bleibende Einsatzaufnahme 13a, 13b eingesetzt werden, um das einzelne Halteelement 21 in der anderen Einsatzaufnahme 13a, 13b axial zu fixieren (falls die Klemmkraft der Federstege/stegförmigen Vorsprünge 20d der Halteeinrichtung 20 des einzelnen Halteelementes 21 nicht ausreichen sollte).

Die in Fig. 14 gezeigte interne Halterung bildet einen Lüfter-Clip 24 zur Halterung eines Lüfters innerhalb des Gehäuses 1, z.B. zur Kühlung von elektronischen Bauteilen.

Der Lüfter-Clip 24 umfasst die Halteeinrichtung 20, einen u-förmigen Bügel 25 und einen Federarm 26.

Der Bügel 25 ist u-förmig mit zwei parallelen Bügelarmen 25a und mit einem halbkreisförmigen Verbinder 25b ausgebildet. Im Gegensatz zu dem Bügel 21a des Halteelementes 21 sind bei diesem Bügel 25 die Enden der Bügelarme 25a zusammen mit dem Verbinder 25d ringartig mit einer dreiviertelkreisförmigen Aufnahme 25d geformt.

An dem vorderen Ende des Verbinders 25d ist eine Ausnehmung 25c eingeformt, welche zur Positionierung eines zu haltenden Lüfters (nicht gezeigt) dient.

Die Bügelarme 25a sind an den Außenseiten der schrägen Halteplatten 20b der Halteeinrichtung 20 in einem unteren Drittel der Halteplatten 20b angebracht. Der Bügel 25 liegt mit seiner u-Form in einer Ebene rechtwinklig zu einer gedachten Längsachse der Aufnahme 20c der Halteeinrichtung 20.

Oberhalb des Bügels 25 ist der Federarm 26 in einem oberen Bereich an der Verbindung der schrägen Halteplatten 20b der Halteeinrichtung 20 angebracht. Eine Oberseite des Federarms 26 fluchtet mit der Oberseite der Halteplatten 20a, 20b der Halteeinrichtung 20. Zwischen der Unterseite des Federarms 26 und dem Bügel 25 ist ein Halteraum 27 gebildet, welcher hier eine größere Weite als der Halteraum 23 des Halteelementes 21 hat. Der Federarm 26 liegt in einer Ebene parallel zu der Ebene des Bügels 25 über dem Zwischenraum, welcher von den Bügelarmen 25a des Bügels 25 gebildet ist. Das freie Ende des Federarms 26 ist abgerundet und trägt an der Unterseite einen kugelartigen Vorsprung 26a. Eine Länge des Federarms 26 entspricht etwa der Länge des Zwischenraums zwischen den Bügelarmen 25a.

Der Abstand zwischen dem Federarm 26 und dem Bügel 25 ist an eine Haltefläche des zu haltenden Lüfters angepasst. Der Vorsprung 26a dient zur Fixierung des Lüfters. Der Vorsprung 26a wird beim Einschieben der Haltefläche des Lüfters zwischen Bügel 25 und Vorsprung 26a aufgrund einer leicht angeschrägten Frontseite des Vorsprungs 26a zusammen mit dem Federarm 26 hochgedrückt und rastet in eine für den Vorsprung 26a vorgesehene Einformung der Haltefläche des Lüfters ein. Beim Hochdrücken des Federarms 26 wird dieser gespannt und drückt den Vorsprung 26a in die für ihn vorgesehene Einformung mit einer vorbestimmten Kraft hinein.

Beim Einschieben der Haltefläche des Lüfters wird dieser positioniert, indem ein passender Abschnitt (nicht gezeigt) der Haltefläche des Lüfters in die Ausnehmung 25c des Bügels 25 formschlüssig eingreift.

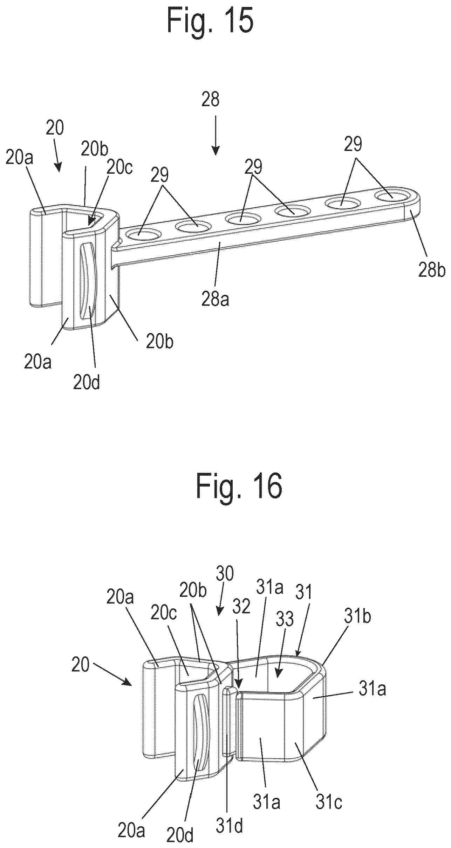

Eine weitere interne Halterung zeigt Fig. 15 in Gestalt eines Bohrungs-Clips 28.

Der Bohrungs-Clip 28 umfasst die Halteeinrichtung 20 und einen Haltearm 28a mit Bohrungen 29.

Der Haltearm 28a weist an seinem freien Ende einen abgerundeten Endabschnitt 28b auf. In einem oberen Drittel an den Außenseiten der schrägen Halteplatten 20b der Halteeinrichtung 20 ist der Haltearm 28a befestigt. Der Haltearm 28a liegt in einer Ebene rechtwinklig zu einer gedachten Längsachse der Aufnahme 20c der Halteeinrichtung 20.

Die Bohrungen 29 sind in diesem Beispiel als Durchgangslöcher mit gleichem Durchmesser und in regelmäßigen Abständen in den Haltearm 28a eingeformt. Die Bohrungen 29 dienen als universelle Befestigungslöcher für unterschiedliches Zubehör. Die Bohrungen 29 können auch als Halt für Kabelbinder dienen.

Ein Kabel-Clip 30 als interne Halterung für elektrische und/oder optische Leitungen/Kabel etc. ist in Fig. 16 dargestellt.

Der Kabel-Clip 30 umfasst die Halteeinrichtung 20 und einen Haltebogen 31.

Der Haltebogen 31 weist einen rechteckigen Querschnitt auf, dessen lange Seite etwa drei Viertel der langen Seite der Halteplatten 20b der Halteeinrichtung 20 entsprechen.

In dem gezeigten Beispiel umfasst der Haltebogen 31 drei Plattenabschnitte 31a und zwei Bogenabschnitte 31b und 31c. Diese Abschnitte sind in abwechselnder Reihenfolge untereinander verbunden. So ist ein Ende eines ersten Plattenabschnitts 31a an einer der schrägen Halteplatten 20b der Halteeinrichtung 20 befestigt. An dem anderen Ende ist ein erster Bogenabschnitt 31b angebracht, der einen großen Radius aufweist und mit einem zweiten Plattenabschnitt 31a verbunden ist. Der zweite Plattenabschnitt 31a seinerseits ist mit einem zweiten Bogenabschnitt 31c, der einen kleinen Radius aufweist, verbunden. Schließlich ist ein dritter Plattenabschnitt 31a an dem zweiten Bogenabschnitt 31c befestigt. Ein Ende des dritten Plattenabschnitts 31a steht einem Steg 31d, der an der anderen der beiden Halteplatten 20b der Halteeinrichtung 20 angebracht ist, in einem Abstand 32 gegenüber.

Auf diese Weise umgibt der Haltebogen 31 ringförmig einen Aufnahmeraum 33, durch welchen sich Kabel und/oder Leitungen erstrecken und von dem Haltebogen 31 gebündelt und gehalten werden. Der Haltebogen 31 ist federnd ausgebildet, wobei der Aufnahmeraum 33 durch Vergrößern des Abstands 32 aufgeweitet werden kann, da der dritte Plattenabschnitt 31a mit seinem Ende nicht an dem Steg 31d befestigt ist.

Das Gehäuse 1 ist in den beschriebenen Beispielen aus einem geeigneten Kunststoff hergestellt. Das Gehäuse 1 kann in Teilen oder auch vollständig aus einem transparenten Werkstoff bestehen. Die externen Halterungen 17, 19 und internen Halterungen 21, 24, 28, 30 sind hier als einstückige Kunststoffteile ausgebildet. Selbstverständlich können alle Teile aus Metall oder auch aus Kombinationen von anderen Werkstoffen, wie z.B. Kunststoff und Metall, erstellt sein.

Die externen Halterungen 17, 19 und internen Halterungen 21, 24, 28, 30 sind nicht auf die gezeigten Ausführungen und Anzahlen beschränkt. Für verschiedene Einsatzzwecke können sie natürlich entsprechend angepasst ausgestaltet sein.

Weitere nicht gezeigte, aber leicht vorstellbare Ausführungen des Grundrahmens 2 weisen beispielsweise nur eine Ecksäule 5 oder zwei oder drei Ecksäulen 5 auf. In diesem Fall sind die Seitenwände 6, 6a jeweils in den Ecken ohne Ecksäule 5 miteinander verbunden, wobei nur eine, nur zwei oder nur drei Ecken mit einer Ecksäule 5 versehen sind. Ein jeweiliger passender Zusatzrahmen 2a ist ebenfalls möglich. Eine Verbindung der Rahmen 2, 2a erfolgt dabei wie oben beschrieben durch Befestigungselemente 15, 16 in der Ecksäule 5. Anstelle der fehlenden Ecksäulen 5 sind Klemmelemente denkbar. Die Magnetverschlüsse können in den Ecken ohne Ecksäulen 5 auch verwendet werden, indem die Magnete 14 in den Wandecken an den Seitenwänden 6 angebracht sind, z.B. durch direktes Ankleben oder indirektes Ankleben von kleinen Taschen, in denen die Magnete 14 befestigt sein können.

Hierbei ist es natürlich auch möglich, Einschubwände 8 wie oben beschrieben zu verwenden.

Das Gehäuse 1 kann auch einen Grundrahmen 2 und mehrere Zusatzrahmen 2a umfassen. Ebenso können zwei Grundrahmen 2 verwendet werden. Es sind zahlreiche Kombinationen möglich, wie z.B. nur Zusatzrahmen 2a, also ein geschlossenes Gehäuse 1.

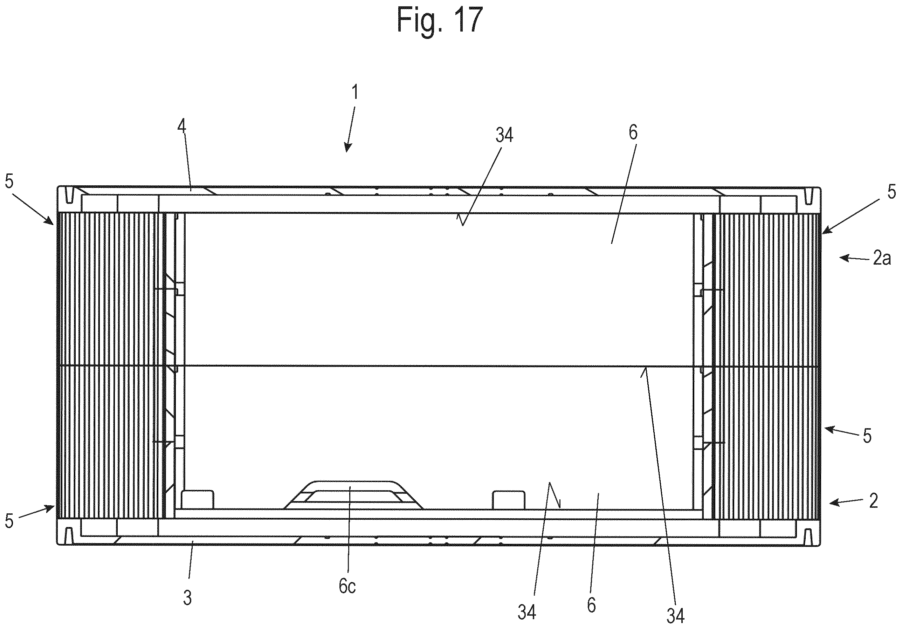

Fig. 17 zeigt eine schematische Schnittansicht einer Variante des Gehäuses 1. Der Schnitt verläuft in einer Längsrichtung des Gehäuses 1 durch dessen Mitte parallel zu den Seitenwänden 6.

Das Gehäuse 1 kann mit einer oder mehreren Lüftungsöffnungen 34, z.B. Lüftungsschlitzen, an verschiedenen Stellen versehen sein. Anstelle der Lüftungsöffnungen 34, oder auch zusätzlich, können auch Kühlkörper eingesetzt sein.

Lüftungsschlitze können auch zwischen den Seitenwänden 6 und dem Bodendeckel 3 und dem Deckel 4 angeordnet sein. Weitere Lüftungsmaßnahmen für den Innenraum des Gehäuses 1 können mittels Durchgangslöcher (kreisrund, oval, rechteckig, schlitzförmig u.dgl.) in dem Bodendeckel 3 und dem Deckel 4, sowie auch in den Seitenwänden 6, 6a und Einschubwänden 8 vorgesehen sein. Diese Art von Lüftungen kann natürlich auch vom Benutzer nachträglich vorgenommen werden.

Die Erfindung ist durch das oben beschriebene Ausführungsbeispiel nicht eingeschränkt, sondern im Rahmen der Ansprüche modifizierbar.

Es ist beispielsweise denkbar, dass anstelle von zwei oder drei einzelnen Einschubwänden 8 wie beispielsweise in Fig. 4 gezeigt eine große Einschubwand in der Höhe von drei Einschubwänden 8 verwendet wird.

Die Deckel 3, 4 und/oder die Wände 6, 6a, 8 können auch aus mehreren Teilen bestehen. Beispielsweise können an ihnen auch Klappen vorgesehen sein.

**Bezugszeichenliste**

| | |
|---|---|
| Gehäuse | 1 |
| Grundrahmen | 2 |
| Zusatzrahmen | 2a |
| Bodendeckel | 3 |
| Säulenabdeckung | 3a |
| Deckel | 4 |
| Säulenabdeckung | 4a |
| Ecksäule | 5 |
| Außenmantel | 5a |
| Seitenwand | 6, 6a |
| Verlängerung | 6b |
| Wanne | 6c |
| Plattenelement | 6d, 6e |
| Haltewand | 7 |
| Haltewinkel | 7a |
| Verlängerung | 7b |
| Einschubwand | 8 |
| Innensäule | 9 |
| Flächensegment | 9a |
| Innensäulenabschnitt | 9b, 9c |
| Bund | 9d |
| Kanal | 10 |
| Kanalwand | 10a |
| Kanalabdeckung | 10b |
| Aufnahme | 10c |
| Halteabschnitt | 11 |
| Haltesteg | 12 |
| Längssteg | 13 |
| Einsatzaufnahme | 13a, 13b |
| Quersteg | 13c |
| Magnet | 14 |
| Befestigungselement | 15, 16 |
| Befestigungsbügel | 17 |
| Basisplatte | 17a |
| Klemmabschnitt | 17b |
| Verbindung | 17c |
| Durchgangsöffnung | 17d |
| Ausnehmung | 17e |
| Öffnung | 17f |
| Halterung | 18 |
| Haltebacke | 18a |
| Durchgangsöffnung | 18b |
| Halter | 19 |
| Basisplatte | 19a |
| Klemmabschnitt | 19b |
| Haltebacke | 19c |
| Durchgangsöffnung | 19d |
| Halteeinrichtung | 20 |
| Halteplatte | 20a, 20b |
| Aufnahme | 20c |
| Vorsprung | 20d |
| Halteelement | 21 |
| Bügel | 21a |
| Bügelarm | 21b |
| Verbinder | 21c |
| Federarm | 22 |
| Vorsprung | 22a |
| Fase | 22b |
| Halteraum | 23 |
| Lüfter-Clip | 24 |
| Bügel | 25 |
| Bügelarm | 25a |
| Verbinder | 25b |
| Ausnehmung | 25c |
| Aufnahme | 25d |
| Federarm | 26 |
| Vorsprung | 26a |
| Halteraum | 27 |
| Bohrungs-Clip | 28 |
| Haltearm | 28a |
| Endabschnitt | 28b |
| Durchgangsöffnung | 29 |
| Kabel-Clip | 30 |
| Haltebogen | 31 |
| Plattenabschnitt | 31a |
| Bogenabschnitt | 31b, 31c |
| Steg | 31d |
| Abstand | 32 |
| Aufnahmeraum | 33 |
| Lüftungsöffnung | 34 |
| Frontseite | F |
| Rückseite | R |

## Patentansprüche

1. Gehäusesystem für elektrische und elektronische Baugruppen, insbesondere für Einplatinencomputer und Zubehör, mit einem Gehäuse (1), mit festen Seitenwänden (6, 6a) und Einschubwänden (8) und mit mindestens einem Deckel (3, 4), wobei das Gehäuse (1) mindestens einen Grundrahmen (2) mit den festen Seitenwänden (6, 6a) und mit mindestens einer Ecksäule (5) aufweist, wobei die mindestens eine Ecksäule (5) Schnittstellen für externe Halterungen (17, 19) und interne Halterungen (21, 24, 28, 30) bildet, wobei der mindestens eine Grundrahmen (2) vier Ecksäulen (5) aufweist, die mit den festen Seitenwänden (6, 6a) untereinander fest verbunden sind, wobei sich zwei feste Seitenwände (6), welche der Höhe der Ecksäulen (5) entsprechen, gegenüberstehen, wobei sich zwei andere feste Seitenwände (6a), welche der halben Höhe der Ecksäulen (5) entsprechen, gegenüberstehen, **dadurch gekennzeichnet, dass** die festen Seitenwände (6a) mit einer halben Höhe der Ecksäulen (5) zum Inneren des Grundrahmens (2) hin versetzt und jeweils an jeder Seite über kurze Haltewände (7) mit den zugehörigen Ecksäulen (5) verbunden sind.

2. Gehäusesystem nach Anspruch 1, **dadurch gekennzeichnet, dass** das Gehäuse (1) mindestens einen Zusatzrahmen (2a) mit mindestens einer Ecksäule (5) aufweist.

3. Gehäusesystem nach Anspruch 2, **dadurch gekennzeichnet, dass** der mindestens eine Zusatzrahmen (2a) vier Ecksäulen (5) aufweist, von denen jeweils zwei Ecksäulen (5) mit den festen Seitenwänden (6, 6a) fest verbunden sind.

4. Gehäusesystem nach einem der Ansprüche 1 bis 3, **dadurch gekennzeichnet, dass** die mindestens eine Ecksäule (5) einen Außenmantel (5a) in Form eines Teil-Hohlzylinders mit einem Dreiviertelkreisquerschnitt aufweist, wobei der Außenmantel (5a) der mindestens einen Ecksäule (5) die Schnittstelle für externe Halterungen (17, 19) ist.

5. Gehäusesystem nach Anspruch 4, weiterhin aufweisend mindestens eine externe Halterung (17, 19), **dadurch gekennzeichnet, dass** die mindestens eine externe Halterung (17, 19) mindestens einen Klemmabschnitt (17b, 19b) mit einem halbkreisförmigen Querschnitt aufweist, dessen Innenradius mit dem Außenradius des Außenmantels (5a) als Schnittstelle für externe Halterungen (17, 19) der mindestens einen Ecksäule (5) korrespondiert.

6. Gehäusesystem nach Anspruch 4 oder 5, **dadurch gekennzeichnet, dass** in dem Außenmantel (5a) der mindestens einen Ecksäule (5) eine Innensäule (9) mit einer zentralen Durchgangsöffnung angeordnet ist.

7. Gehäusesystem nach Anspruch 6, **dadurch gekennzeichnet, dass** die Durchgangsöffnung der Innensäule (9) als Innensechskantquerschnitt ausgebildet ist.

8. Gehäusesystem nach Anspruch 6 oder 7, **dadurch gekennzeichnet, dass** an der Innensäule (9) eine sich längs der Innensäule (9) erstreckende Kanalwand (10a) mit einem Kanal (10) angeordnet ist.

9. Gehäusesystem nach Anspruch 8, **dadurch gekennzeichnet, dass** auf jeder Seite der Kanalwand (10a) ein Halteabschnitt (11) durch eine Verlängerung (6b, 7b) der an der Ecksäule (5) angebrachten Seitenwand (6,7), die Kanalwand (10a) und einen an der Seitenwand (6, 7) angebrachten Steg (12) festgelegt ist, wobei diese beiden Halteabschnitte (11) eine Einsatzaufnahme (13a, 13b) als Schnittstelle für interne Halterungen (21, 24, 28, 30) bilden.

10. Gehäusesystem nach Anspruch 9, **dadurch gekennzeichnet, dass** die Einsatzaufnahme (13a, 13b) weiterhin einen in Längsrichtung der Kanalwand (10) an dieser befestigten Steg (13) aufweist, welcher eine Trennung der beiden Halteabschnitte (11) in Längsrichtung bildet.

11. Gehäusesystem nach Anspruch 10, **dadurch gekennzeichnet, dass** die beiden Halteabschnitte (11) in einer Querrichtung durch einen Quersteg (13c) geteilt sind und zwei Einsatzaufnahmen (13a, 13b) bilden, wobei die Einsatzaufnahmen (13a, 13b) jeweils zu einem Innenraum des zugehörigen Rahmens (2, 2a) hin geöffnet sind, wobei die jeweilige Öffnung durch die Stege (12), den Steg (13) und den Quersteg (13c) festgelegt ist, und wobei die Einsatzaufnahmen (13a, 13b) die Schnittstelle für interne Halterungen (21, 24, 28, 30) der mindestens einen Ecksäule (5) bilden.

12. Gehäusesystem nach Anspruch 11, weiterhin aufweisend mindestens eine interne Halterung (21, 24, 28, 30), **dadurch gekennzeichnet, dass** die mindestens eine interne Halterung (21, 24, 28, 30) eine Halteeinrichtung (20) aufweist, deren Form für einen formschlüssigen Eingriff mit der Form der Einsatzaufnahme (13a, 13b) als Schnittstelle für interne Halterungen (21, 24, 28, 30) der mindestens einen Ecksäule (5) korrespondiert.

13. Gehäusesystem nach Anspruch 12, **dadurch gekennzeichnet, dass** die Halteeinrichtung (20) stegförmige Vorsprünge (20d) oder/und vorgespannte Federstege aufweist, welche die Halteeinrichtung (20) in den Halteabschnitten (11) formschlüssig und durch Reibkraft kraftschlüssig festlegen.

14. Gehäusesystem nach einem der Ansprüche 6 bis 13, **dadurch gekennzeichnet, dass** das Gehäuse (1) mit Befestigungselementen (15, 16), vorzugsweise Schrauben und Muttern, welche in der Durchgangsöffnung der Innensäule (9) der mindestens einen Ecksäule (5) angeordnet sind, zusammengehalten ist.

15. Gehäusesystem nach einem der Ansprüche 6 bis 14, **dadurch gekennzeichnet, dass** das Gehäuse (1) mit Magneten (14), die als Permanentmagneten Magnetverschlüsse bilden, zusammengehalten ist.

16. Gehäusesystem nach Anspruch 15, **dadurch gekennzeichnet, dass** die Magneten (14) der Magnetverschlüsse in den Eingängen der Durchgangsöffnung der Innensäule (9) der mindestens einen Ecksäule (5) und in Aufnahmen (10c) in den Deckeln (3, 4) angeordnet sind.

17. Gehäusesystem nach einem der vorhergehenden Ansprüche **dadurch gekennzeichnet, dass** die Deckel (3, 4) Säulenabdeckungen (3a, 4a) aufweisen, welche die Ecksäulen (5) verschließen.

## Claims

1. A housing system for electrical and electronic components, in particular for single-board computers and accessories, with a housing (1), with fixed side walls (6, 6a) and slide-in walls (8) and with at least one cover (3, 4), wherein the housing (1) has at least one basic frame (2) with the fixed side walls (6, 6a) and with at least one corner pillar (5), wherein the at least one corner pillar (5) forms interfaces for external mounts (17, 19) and internal mounts (21, 24, 28, 30), wherein the at least one basic frame (2) has four corner pillars (5) which are firmly connected to each other with the fixed side walls (6, 6a), wherein two fixed side walls (6) which correspond to the height of the corner pillars (5) are opposite each other, wherein two other fixed side walls (6a) which correspond to half the height of the corner pillars (5) are opposite each other, **characterized in that** the fixed side walls (6a) are offset towards the interior of the basic frame (2) by half the height of the corner pillars (5) and are connected to the associated corner pillars (5) on each side by short holding walls (7).

2. The housing system according to Claim 1, **characterized in that** the housing (1) has at least one supplementary frame (2a) with at least one corner pillar (5).

3. The housing system according to Claim 2, **characterized in that** the at least one supplementary frame (2a) has four corner pillars (5), two corner pillars (5) of which in each case are firmly connected to the fixed side walls (6, 6a).

4. The housing system according to any one of Claims 1 to 3, **characterized in that** the at least one corner pillar (5) has an outer jacket (5a) in the form of a partially hollow cylinder with a three-quarter circular cross-section, wherein the outer jacket (5a) of the at least one corner pillar (5) is the interface for external mounts (17, 19).

5. The housing system according to Claim 4, furthermore having at least one external mount (17, 19), **characterized in that** the at least one external mount (17, 19) has at least one clamping section (17b, 19b) having a semicircular cross-section, the internal radius of which corresponds to the external radius of the outer jacket (5a) as an interface for external mounts (17, 19) of the at least one corner pillar (5).

6. The housing system according to Claim 4 or 5, **characterized in that** an inner pillar (9) with a central through-opening is arranged in the outer jacket (5a) of the at least one corner pillar (5).

7. The housing system according to Claim 6, **characterized in that** the through-opening of the inner pillar (9) is configured as an internally hexagonal cross-section.

8. The housing system according to Claim 6 or 7, **characterized in that** a channel wall (10a) which extends along the inner pillar (9) and has a channel (10) is arranged on the inner pillar (9).

9. The housing system according to Claim 8, **characterized in that**, on each side of the channel wall (10a), a holding section (11) is defined by a prolongation (6b, 7b) of the side wall (6,7) attached to the corner pillar (5), the channel wall (10a) and a bar (12) attached to the side wall (6, 7), wherein these two holding sections (11) form an insert receptacle (13a, 13b) as an interface for internal mounts (21, 24, 28, 30).

10. The housing system according to Claim 9, **characterized in that** the insert receptacle (13a, 13b) furthermore has a bar (13) which is secured to this in the longitudinal direction of the channel wall (10) and which forms a separation of the two holding sections (11) in the longitudinal direction.

11. The housing system according to Claim 10, **characterized in that** the two holding sections (11) are divided in a transverse direction by a crossbar (13c) and form two insert receptacles (13a, 13b), wherein the insert receptacles (13a, 13b) are each opened towards an interior space of the associated frame (2, 2a), wherein in each case the opening is defined by the bars (12), the bar (13) and the crossbar (13c), and wherein the insert receptacles (13a, 13b) form the interface for internal mounts (21, 24, 28, 30) of the at least one corner pillar (5).

12. The housing system according to Claim 11, furthermore having at least one internal mount (21, 24, 28, 30), **characterized in that** the at least one internal mount (21, 24, 28, 30) has a holding device (20), the shape of which, for form-fitting engagement, corresponds to the shape of the insert receptacle (13a, 13b) as an interface for internal mounts (21, 24, 28, 30) of the at least one corner pillar (5).

13. The housing system according to Claim 12, **characterized in that** the holding device (20) has bar-shaped protrusions (20d) or/and prestressed spring bars, which fix the holding device (20) in the holding sections (11) in a form-fitting manner and in a force-fitting manner by friction.

14. The housing system according to any one of Claims 6 to 13, **characterized in that** the housing (1) is held together by securing elements (15, 16), preferably screws and nuts, which are arranged in the through-opening of the inner pillar (9) of the at least one corner pillar (5).

15. The housing system according to any one of Claims 6 to 14, **characterized in that** the housing (1) is held together by magnets (14), which, as permanent magnets, form magnetic closures.

16. The housing system according to Claim 15, **characterized in that** the magnets (14) of the magnetic closures are arranged in the entrances to the through-opening of the inner pillar (9) of the at least one corner pillar (5) and in receptacles (10c) in the covers (3, 4).

17. The housing system according to any one of the preceding claims, **characterized in that** the covers (3, 4) have pillar caps (3a, 4a) which enclose the corner pillars (5).

## Revendications

1. Système de boîtier pour modules électriques et électroniques, en particulier pour ordinateurs à carte unique et accessoires, avec un boîtier (1) possédant des parois latérales fixes (6, 6a) et des cloisons insérées (8) et au moins un couvercle (3, 4), lequel boîtier (1) comporte au moins un cadre de base (2) avec les parois latérales fixes (6, 6a) et avec au moins un montant d'angle (5),
dans lequel l'au moins un montant d'angle (5) forme des interfaces pour des éléments de maintien externes (17, 19) et des éléments de maintien internes (21, 24, 28, 30),
dans lequel l'au moins un cadre de base (2) comporte quatre montants d'angle (5) qui sont reliés à demeure les uns avec les autres avec les parois latérales fixes (6, 6a), deux parois latérales fixes (6) qui correspondent à la hauteur des montants d'angle (5) se faisant face, deux autres parois latérales fixes (6a) qui correspondent à la moitié de la hauteur des montants d'angle (5) se faisant face, **caractérisé en ce que** les parois latérales fixes (6a) ayant la moitié de la hauteur des montants d'angle (5) sont décalées vers l'intérieur du cadre de base (2) et reliées chacune de chaque côté aux montants d'angle (5) correspondants par des parois de maintien (7) courtes.

2. Système de boîtier selon la revendication 1, **caractérisé en ce que** le boîtier (1) comporte au moins un cadre supplémentaire (2a) avec au moins un montant d'angle (5).

3. Système de boîtier selon la revendication 2, **caractérisé en ce que** l'au moins un cadre supplémentaire (2a) comporte quatre montants d'angle (5), dont deux montants d'angle (5) fixés à demeure aux parois latérales fixes (6, 6a).

4. Système de boîtier selon l'une des revendications 1 à 3, **caractérisé en ce que** l'au moins un montant d'angle (5) comporte une enveloppe extérieure (5a) prenant la forme d'un cylindre creux partiel ayant une section de trois quarts de cercle, l'enveloppe extérieure (5a) de l'au moins un montant d'angle (5) étant l'interface pour des éléments de maintien externes (17, 19).

5. Système de boîtier selon la revendication 4, comportant en outre au moins un élément de maintien externe (17, 19), **caractérisé en ce que** l'au moins un élément de maintien externe (17, 19) comporte au moins une partie de serrage (17b, 19b) ayant une section en demi-cercle dont le rayon intérieur correspond au rayon extérieur de l'enveloppe extérieure (5a) qui sert d'interface pour des éléments de maintien externes (17, 19) de l'au moins un montant d'angle (5).

6. Système de boîtier selon la revendication 4 ou 5, **caractérisé en ce qu'**est disposé dans l'enveloppe extérieure (5a) de l'au moins un montant d'angle (5) un montant intérieur (9) muni d'une ouverture traversante centrale.

7. Système de boîtier selon la revendication 6, **caractérisé en ce que** l'ouverture traversante du montant intérieur (9) est conformée avec une section à six pans creux.

8. Système de boîtier selon la revendication 6 ou 7, **caractérisé en ce qu'**est disposée sur le montant intérieur (9) une paroi de canal (10a) munie d'un canal (10) qui s'étend le long du montant intérieur (9).

9. Système de boîtier selon la revendication 8, **caractérisé en ce qu'**une partie de maintien (11) est fixée de chaque côté de la paroi de canal (10a) par un prolongement (6b, 7b) de la paroi latérale (6,7) montée sur le montant d'angle (5), la paroi de canal (10a) et une barrette (12) montée sur la paroi latérale (6, 7), ces deux parties de maintien (11) formant un logement d'insertion (13a, 13b) qui sert d'interface pour des éléments de maintien internes (21, 24, 28, 30).

10. Système de boîtier selon la revendication 9, **caractérisé en ce que** le logement d'insertion (13a, 13b) comporte en outre une barrette (13) fixée dans le sens longitudinal de la paroi de canal (10), qui forme une séparation des deux parties de maintien (11) dans le sens longitudinal.

11. Système de boîtier selon la revendication 10, **caractérisé en ce que** les deux parties de maintien (11) sont partagées dans un sens transversal par une barrette transversale (13c) et forment deux logements d'insertion (13a, 13b), lesquels logements d'insertion (13a, 13b) sont ouverts chacun vers un espace intérieur du cadre (2, 2a) correspondant, l'ouverture correspondante étant définie par les barrettes (12), la barrette (13) et la barrette transversale (13c), et lesquels logements d'insertion (13a, 13b) forment l'interface pour des éléments de maintien internes (21, 24, 28, 30) de l'au moins un montant d'angle (5).

12. Système de boîtier selon la revendication 11, comportant en outre au moins un élément de maintien interne (21, 24, 28, 30), **caractérisé en ce que** l'au moins un élément de maintien interne (21, 24, 28, 30) comporte un dispositif de maintien (20) dont la forme correspond, en vue d'un engagement positif, à la forme du logement d'insertion (13a, 13b) servent d'interface pour des éléments de maintien internes (21, 24, 28, 30) de l'au moins un montant d'angle (5).

13. Système de boîtier selon la revendication 12, **caractérisé en ce que** le dispositif de maintien (20) comporte des saillies (20d) en forme de barrettes et/ou des barrettes à ressort précontraintes, qui fixent le dispositif de maintien (20) dans les parties de maintien (11) par engagement positif et par adhérence par friction.

14. Système de boîtier selon l'une des revendications 6 à 13, **caractérisé en ce que** le boîtier (1) est tenu par des éléments de fixation (15, 16), de préférence des vis et des écrous, qui sont disposés dans l'ouverture traversante du montant intérieur (9) de l'au moins un montant d'angle (5).

15. Système de boîtier selon l'une des revendications 6 à 14, **caractérisé en ce que** le boîtier (1) est tenu par des aimants (14) permanents qui forment des fermetures magnétiques.

16. Système de boîtier selon la revendication 15, **caractérisé en ce que** les aimants (14) des fermetures magnétiques sont disposés dans les entrées de l'ouverture traversante du montant intérieur (9) de l'au moins un montant d'angle (5) et dans des logements (10c) dans les couvercles (3, 4).

17. Système de boîtier selon l'une des revendications précédentes, **caractérisé en ce que** les couvercles (3, 4) comportent des capuchons de montant (3a, 4a) qui ferment les montants d'angle (5).
